# FASCICULE DE BREVET EUROPEEN

(11) **EP 3 090 450 B1**
(45) Date de publication et mention de la délivrance du brevet: **19.02.2020**
(21) Numéro de dépôt: 14820890.3
(22) Date de dépôt: 23.12.2014
(51) Int. Cl.: H01L 33/18, H01L 33/24

(54) **DISPOSITIF OPTOÉLECTRONIQUE À ÉLÉMENTS SEMICONDUCTEURS ET SON PROCÉDÉ DE FABRICATION**
OPTOELEKTRONISCHE VORRICHTUNG MIT HALBLEITERELEMENTEN UND DEREN HERSTELLUNGSVERFAHREN
OPTOELECTRONIC DEVICE COMPRISING SEMICONDUCTOR ELEMENTS AND ITS FABRICATION PROCESS

(30) Priorité: 30.12.2013 FR 1363700
(43) Date de publication de la demande: 09.11.2016
(73) Titulaire: Aledia, 38040 Grenoble Cedex (FR)
(72) Inventeur: DORNEL, Erwan, F-38600 Fontaine (FR); AMSTATT, Benoît, F-38000 Grenoble (FR); GILET, Philippe, F-38470 Teche (FR)
(74) Mandataire: Cabinet Beaumont
(86) Numéro de dépôt international: PCT/EP2014/079276
(87) Numéro de publication internationale: WO 2015/101578

(56) Documents cités:
- US-A1- 2011 079 766
- US-A1- 2011 310 920
- US-A1- 2013 256 689

## Description

La présente demande de brevet revendique la priorité de la demande de brevet français FR13/63700.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des éléments semiconducteurs de taille micrométrique ou nanométrique, notamment des microfils, des nanofils semiconducteurs ou des structures de forme pyramidale.

### Exposé de l'art antérieur

Les éléments semiconducteurs de taille micrométrique ou nanométrique, notamment les microfils, les nanofils ou les structures de forme pyramidale comprenant un matériau semiconducteur comportant notamment majoritairement un élément du groupe III et un élément du groupe V (par exemple du nitrure de gallium GaN), appelés par la suite composé III-V, permettent la fabrication de dispositifs semiconducteurs tels que des dispositifs optoélectroniques. Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés aux applications photovoltaïques.

Les procédés de fabrication d'éléments semiconducteurs de taille micrométrique ou nanométrique comprenant un composé III-V doivent permettre la fabrication de ces éléments semiconducteurs avec un contrôle précis et uniforme de la géométrie, de la position et des propriétés cristallographiques de chaque élément semiconducteur.

La fabrication d'un dispositif optoélectronique comprenant des éléments semiconducteurs de taille nanométrique ou micrométrique comprend généralement la formation de germes sur une couche en un matériau favorisant la formation de germes du composé III-V, appelée couche de nucléation, la croissance des éléments semiconducteurs à partir des germes et la formation d'une couche active sur chaque élément semiconducteur. Pour contrôler les emplacements de croissance des éléments semiconducteurs, la couche de nucléation est, par exemple, recouverte d'une couche isolante dans laquelle sont réalisées des ouvertures exposant des portions de la couche de nucléation.

Il est souhaitable qu'un seul germe se forme sur la couche de nucléation dans chaque ouverture. Toutefois, plusieurs germes peuvent se former dans une même ouverture. Ceci peut entraîner la croissance de plusieurs éléments semiconducteurs depuis une même ouverture. Un mauvais contrôle de la croissance de ces éléments semiconducteurs est alors obtenu, notamment en ce qui concerne la hauteur et l'orientation de chaque élément semiconducteur. Ceci peut mener à une dégradation du fonctionnement du dispositif optoélectronique. Le document US 2013/0256689 A1 divulgue un dispositif optoélectronique à nanofils, comprenant des nanofils formés au travers d'ouvertures dans une couche isolante formée sur un substrat.

### Résumé

Ainsi, un objet d'un mode de réalisation est de pallier au moins en partie les inconvénients des procédés de fabrication de dispositifs optoélectroniques comprenant des éléments semiconducteurs de taille micrométrique ou nanométrique, notamment des microfils, des nanofils semiconducteurs ou des structures de forme pyramidale, décrits précédemment et de leurs procédés de fabrication.

Un autre objet d'un mode de réalisation est d'obtenir la croissance d'un seul élément semiconducteur depuis chaque ouverture de la couche isolante recouvrant la couche de germination.

Un autre objet d'un mode de réalisation est de contrôler l'orientation de l'élément semiconducteur croissant depuis chaque ouverture de la couche isolante recouvrant la couche de germination.

Un autre objet d'un mode de réalisation de la présente invention est que la position, la géométrie et les propriétés cristallographiques de chaque élément semiconducteur en composé III-V peuvent être contrôlées de façon précise et uniforme.

Un autre objet d'un mode de réalisation est que les dispositifs optoélectroniques à éléments semiconducteurs de taille nanométrique ou micrométrique puissent être fabriqués à une échelle industrielle et à bas coût.

Ainsi, un mode de réalisation prévoit un dispositif optoélectronique comprenant des éléments semiconducteurs, chaque élément semiconducteur reposant sur un support au travers d'une ouverture formée dans une portion recouvrant au moins partiellement le support et dont au moins une première partie est isolante, la hauteur de l'ouverture étant supérieure ou égale à 100 nm et inférieure ou égale à 3000 nm et le rapport entre la hauteur et le plus petit diamètre de l'ouverture étant supérieur ou égal à 0,5 et inférieur ou égal à 10.

Selon un mode de réalisation, les éléments semiconducteurs sont des nanofils, des microfils et/ou des structures pyramidales de taille nanométrique ou micrométrique.

Selon un mode de réalisation, la hauteur est supérieure ou égale à 200 nm.

Selon un mode de réalisation, le rapport est supérieur ou égal à 1.

Selon un mode de réalisation, le diamètre moyen de l'ouverture est constant sur toute la hauteur de la portion.

Selon un mode de réalisation, le diamètre moyen de l'ouverture diminue de façon continue depuis le sommet de l'ouverture jusqu'à la base de l'ouverture.

Selon un mode de réalisation, l'ouverture comprend successivement depuis la base de l'ouverture une première partie et une deuxième partie, le diamètre moyen de la première partie étant constant sur toute la hauteur de la première partie et le diamètre moyen de la deuxième partie étant constant sur toute la hauteur de la deuxième partie et différent du diamètre moyen de la première partie.

Selon un mode de réalisation, le diamètre moyen de la première partie est strictement inférieur au diamètre moyen de la deuxième partie.

Selon un mode de réalisation, le diamètre moyen de la première partie est strictement supérieur au diamètre moyen de la deuxième partie.

Selon un mode de réalisation, la première partie de la portion comprend au moins l'un des matériaux parmi les oxydes de silicium, les nitrures de silicium et les oxydes d'aluminium.

Selon un mode de réalisation, au moins une deuxième partie de la portion comprend au moins un matériau non isolant électriquement.

Selon un mode de réalisation, la deuxième partie de la portion comprend au moins l'un des matériaux choisis parmi le groupe comprenant AlN, Ti, TiN, Ta, TaN, Hf, HfN, W, WN, Mo.

Selon un mode de réalisation, chaque élément semiconducteur est majoritairement en un composé III-V.

Selon un mode de réalisation, chaque élément semiconducteur comprend majoritairement du nitrure de gallium.

Un mode de réalisation prévoit un procédé de fabrication d'un dispositif optoélectronique comprenant les étapes suivantes :
former, sur un support, une portion recouvrant au moins partiellement le support et dont au moins une première partie est isolante ;
former une ouverture traversant la portion, la hauteur de l'ouverture étant supérieure ou égale à 100 nm et inférieure ou égale à 3000 nm et le rapport entre la hauteur et le diamètre moyen de l'ouverture au sommet de la portion étant supérieur ou égal à 0,5 et inférieur ou égal à 10 ; et
faire croître dans chaque ouverture un élément semiconducteur reposant sur le support.

Selon un mode de réalisation, la hauteur de la portion est supérieure ou égale à 100 nm et inférieure ou égale à 1000 nm.

Selon un mode de réalisation, la formation de la portion comprend les étapes suivantes :
déposer une première couche isolante comprenant un premier matériau isolant ;
déposer une deuxième couche isolante comprenant un deuxième matériau isolant différent du premier matériau isolant ;
former une première partie de l'ouverture dans la première couche isolante ;
former une deuxième partie de l'ouverture dans la deuxième partie de la couche isolante, le diamètre moyen de la première partie étant différent du diamètre moyen de la deuxième partie ; et
faire croître dans chaque première et deuxième parties de l'ouverture un élément semiconducteur reposant sur le support.

Selon un mode de réalisation, la formation de la portion comprend les étapes suivantes :
dépôt d'une première couche isolante comprenant un premier matériau isolant ;
former une première partie de l'ouverture dans la première couche isolante ;
dépôt d'une deuxième couche isolante comprenant un deuxième matériau isolant différent du premier matériau isolant ;
former une deuxième partie de l'ouverture dans la deuxième partie de la couche isolante, le diamètre moyen de la première partie étant différent du diamètre moyen de la deuxième partie ; et
faire croître dans chaque première et deuxième parties de l'ouverture un élément semiconducteur reposant sur le support.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif optoélectronique à microfils ou nanofils ;
les figures 2A à 2C sont des coupes, partielles et schématiques, des structures obtenues à des étapes successives d'un procédé de fabrication du dispositif optoélectronique représenté en figure 1 ;
les figures 3 à 5 sont des vues en coupe, partielles et schématiques, de modes de réalisation de dispositifs optoélectroniques à microfils ou nanofils ;
les figures 6 et 7 sont des vues en coupe, partielles et schématiques, de modes de réalisation de dispositifs optoélectroniques respectivement à pyramides et pyramides tronquées ;
les figures 8A à 8C sont des coupes, partielles et schématiques, des structures obtenues à des étapes successives d'un mode de réalisation d'un procédé de fabrication du dispositif optoélectronique représenté en figure 3 ;
la figure 9 est une coupe, partielle et schématique, de la structure obtenue à une étape d'un mode de réalisation d'un procédé de fabrication du dispositif optoélectronique représenté en figure 7 ;
les figures 10 et 11 sont des vues en coupe, partielles et schématiques, d'autres modes de réalisation de dispositifs optoélectroniques à microfils ou nanofils ;
les figures 12A à 12C et les figures 13A et 13B sont des coupes, partielles et schématiques, des structures obtenues à des étapes successives de modes de réalisation d'un procédé de fabrication du dispositif optoélectronique représenté en figure 11 ;
la figure 14 est une vue en coupe, partielle et schématique, d'un autre mode de réalisation d'un dispositif optoélectronique à microfils ou nanofils ;
les figures 15A à 15C sont des coupes, partielles et schématiques, des structures obtenues à des étapes successives d'un mode de réalisation d'un procédé de fabrication du dispositif optoélectronique représenté en figure 14 ; et
les figures 16A à 16F sont des coupes, partielles et schématiques, des structures obtenues à des étapes successives d'un autre mode de réalisation d'un procédé de fabrication du dispositif optoélectronique représenté en figure 11.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation du dispositif optoélectronique sont bien connus et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques comprenant des éléments semiconducteurs ayant la forme de microfils, de nanofils ou de pyramides.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Dans la suite de la description, le terme pyramide ou pyramide tronquée désigne une structure tridimensionnelle dont une partie est de forme pyramidale ou conique allongée. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

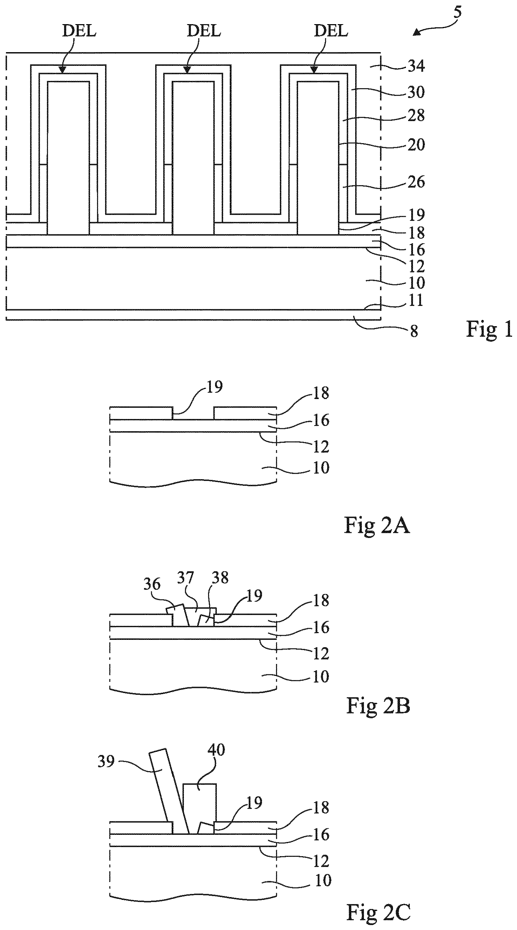

La figure 1 est une vue en coupe, partielle et schématique, d'un exemple d'un dispositif optoélectronique 5 à diodes électroluminescentes.

En figure 1, on a représenté une structure comprenant, du bas vers le haut :
une première électrode 8 ;
un substrat semiconducteur 10 comprenant une face inférieure 11 et une face supérieure 12, la face inférieure 11 étant recouverte de la première électrode 8 et la face supérieure 12 étant de préférence plane au moins au niveau des diodes électroluminescentes ;
une couche de germination 16 en un matériau conducteur favorisant la croissance de fils et disposée sur la face 12 ;
une couche isolante 18 recouvrant la couche de germination 12 et comprenant des ouvertures 19 exposant des portions de la couche de germination 16 ;
des fils 20 (trois fils étant représentés), chaque fil 20 étant en contact avec la couche de germination 16 au travers de l'une des ouvertures 19 ;
une couche isolante 26 s'étendant sur les flancs latéraux d'une portion inférieure de chaque fil 20 ;
une coque 28 comprenant un empilement de couches semiconductrices recouvrant une portion supérieure de chaque fil 20 ;
une couche 30 formant une deuxième électrode recouvrant chaque coque 28 et s'étendant, en outre, sur la couche isolante 26 ; et
une couche d'encapsulation 34 recouvrant l'ensemble de la structure et notamment l'électrode 30.

L'ensemble formé par chaque fil 20 et la coque 28 associée constitue une diode électroluminescente DEL. La coque 28 comprend notamment une couche active qui est la couche depuis laquelle est émise la majorité du rayonnement électromagnétique fourni par la diode électroluminescente DEL. Les diodes électroluminescentes DEL peuvent être connectées en parallèle et former un ensemble de diodes électroluminescentes. L'ensemble peut comprendre de quelques diodes électroluminescentes DEL à un millier de diodes électroluminescentes.

Les figures 2A à 2C illustrent les étapes initiales d'un exemple de procédé de fabrication du dispositif optoélectronique 5 représenté en figure 1.

La figure 2A représente la structure obtenue après les étapes suivantes :
formation sur la face 12 du substrat 10 de la couche de germination 16, par exemple par épitaxie ;
formation de la couche isolante 18 sur la couche de germination 16 ;
formation des ouvertures 19 dans la couche isolante 18, une seule ouverture 19 étant représentée sur les figures 2A à 2C.

La couche isolante 18 peut être en un matériau diélectrique, par exemple en oxyde de silicium (SiO₂). A titre d'exemple, l'épaisseur de la couche isolante 18 est comprise entre 5 nm et 100 nm, par exemple égale à environ 30 nm. La section de chaque ouverture 19 correspond sensiblement à la section souhaitée du fil 20. De préférence, le diamètre du fil 20 est compris entre 100 nm et 1 µm, de préférence entre 300 nm et 800 nm.

La figure 2B représente la structure obtenue après la croissance de germes dans les ouvertures 19, par exemple par dépôt chimique en phase vapeur organométallique (MOCVD, acronyme anglais pour Metal-Organic Chemical Vapor Deposition). Les inventeurs ont mis en évidence que plusieurs germes peuvent se former dans une même ouverture 19, trois germes 36, 37, 38 étant représentés à titre d'exemple en figure 2B.

La figure 2C représente la structure obtenue après la croissance de fils. Comme cela apparaît sur cette figure, lorsque plusieurs germes 36, 37, 38 sont initialement présents dans une même ouverture 19, plusieurs fils 39, 40 peuvent croître depuis cette ouverture 19 avec des axes de croissance différents.

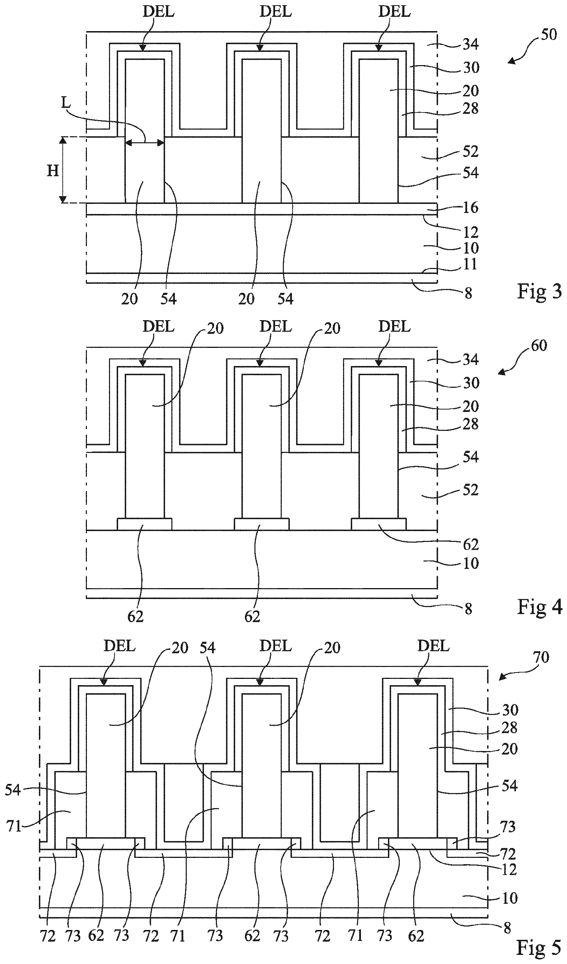

La figure 3 est une vue en coupe, partielle et schématique, d'un mode de réalisation d'un dispositif optoélectronique 50 à diodes électroluminescentes dont les éléments semiconducteurs correspondent à des nanofils ou microfils.

Le dispositif optoélectronique 50 comprend les mêmes éléments que le dispositif optoélectronique 5 représenté en figure 1 à la différence que la couche isolante 18 est remplacée par une couche 52 comprenant des ouvertures 54 dans chacune desquelles croît l'un des fils 20. La couche 52 avec ses ouvertures 54 associées peut présenter des caractéristiques différentes de la couche 18 comme cela est détaillé ci-dessous. Dans la suite de la description, on appelle sommet de l'ouverture 54 l'extrémité de l'ouverture 54 la plus éloignée de la couche de nucléation 16 et base de l'ouverture l'extrémité de l'ouverture 54 la plus proche de la couche de nucléation 16.

La figure 4 est une vue en coupe, partielle et schématique, d'un autre mode de réalisation d'un dispositif optoélectronique 60 à diodes électroluminescentes. Le dispositif optoélectronique 60 comprend les mêmes éléments que le dispositif optoélectronique 50 représenté en figure 3 à la différence que la couche de germination 16 est remplacée par des plots de germination 62, appelés également îlots de germination. Chaque fil 20 croît sur l'un des plots de germination 62.

La figure 5 est une vue en coupe, partielle et schématique, d'un autre mode de réalisation d'un dispositif optoélectronique 70 à diodes électroluminescentes. Le dispositif optoélectronique 70 comprend les mêmes éléments que le dispositif optoélectronique 60 représenté en figure 4 à la différence que la couche isolante 52 est divisée en blocs isolants 71, chaque bloc isolant 71 recouvrant l'un des plots de germination 62 et comprenant l'ouverture 54. Le dispositif optoélectronique 70 comprend, en outre, une région diélectrique 72 qui s'étend dans le substrat 10 depuis la face 12 entre les plots de germination 62 et, éventuellement, une région diélectrique 73 sur les flancs latéraux de chaque portion de germination 62, les fils ne croissant pas sur ces régions diélectriques 72, 73.

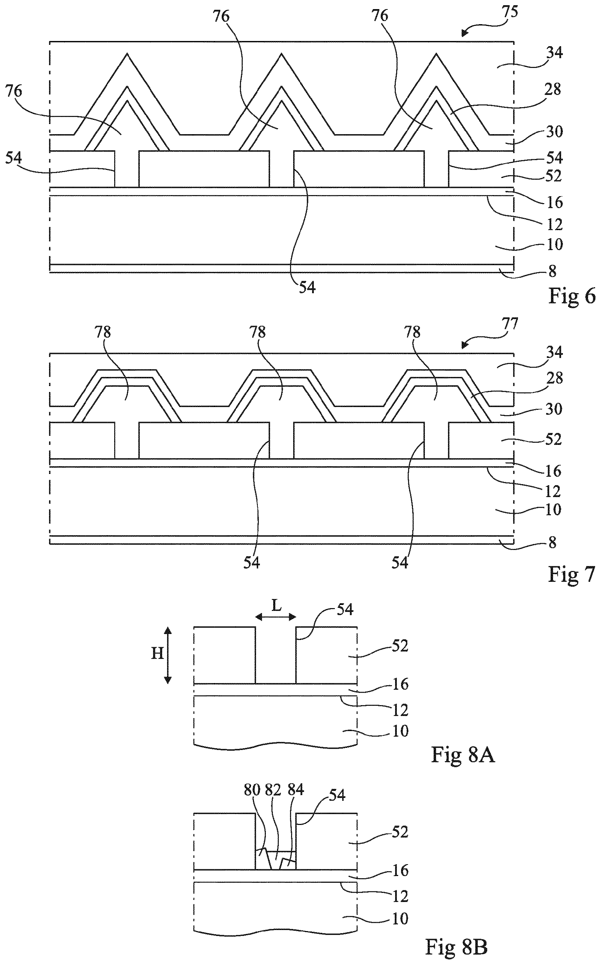

La figure 6 est une vue en coupe, partielle et schématique, d'un autre mode de réalisation d'un dispositif optoélectronique 75 à diodes électroluminescentes. Le dispositif optoélectronique 75 comprend les mêmes éléments que le dispositif optoélectronique 50 représenté en figure 3 à la différence que la partie de chaque fil 20 en dehors de l'ouverture 54 est remplacée par une pyramide 76. La base de la pyramide 76 repose sur la couche 52 et est plus large que l'ouverture 54 sous-jacente.

La figure 7 est une vue en coupe, partielle et schématique, d'un autre mode de réalisation d'un dispositif optoélectronique 77 à diodes électroluminescentes. Le dispositif optoélectronique 77 comprend les mêmes éléments que le dispositif optoélectronique 75 représenté en figure 6 à la différence que chaque pyramide 76 est remplacée par une pyramide tronquée 78. Dans la suite de la description, sauf indication contraire, le terme pyramide désigne indifféremment une pyramide complète 76 telle que représentée en figure 6 ou une pyramide tronquée 78 telle que représentée en figure 7.

Dans le cas de fils 20, le diamètre du fil est sensiblement le même que le diamètre de l'ouverture 54 correspondant. Dans le cas de pyramides 76, 78, on note un élargissement de la structure semiconductrice dès la sortie de l'ouverture 54.

La section droite des ouvertures 54 peut avoir différentes formes, telles que, par exemple, une forme ovale, circulaire ou polygonale, notamment triangulaire, rectangulaire, carrée ou hexagonale. Lorsque l'on mentionne ici le "diamètre" ou "diamètre moyen" dans une section droite d'une ouverture ou d'un fil, il s'agit d'une grandeur associée à la surface de la structure visée dans cette section droite, correspondant, par exemple, au diamètre du disque ayant la même surface que la section droite de l'ouverture ou du fil. Ce même principe de diamètre équivalent peut être appliqué aux structures pyramidales notamment pour la base de la pyramide.

On appelle H la hauteur de l'ouverture 54, c'est-à-dire l'épaisseur de la couche 52, et L le diamètre de l'ouverture 54. De préférence, le diamètre L de l'ouverture 54 est sensiblement constant sur toute la hauteur H. A titre d'exemple, la hauteur H de chaque ouverture 54 est comprise entre 100 nm et 1500 nm, de préférence entre 200 nm et 1000 nm, encore plus préférentiellement entre 300 nm et 1000 nm. A titre d'exemple, le diamètre L de chaque ouverture 54 est compris entre 200 nm et 1 µm, de préférence entre 300 nm et 800 nm. Le rapport F entre la hauteur H et le diamètre L est compris entre 0,5 et 15, de préférence entre 1 et 10, en particulier environ 1,5.

Les inventeurs ont mis en évidence que lorsque les ouvertures 54 avaient les dimensions H, L et F indiquées précédemment, il était observé la croissance d'un seul fil 20 par ouverture 54.

Le substrat 10 peut correspondre à une structure monobloc ou correspondre à une couche recouvrant un support constitué d'un autre matériau. Le substrat 10 est de préférence un substrat semiconducteur, par exemple un substrat en silicium, en germanium, en carbure de silicium, en un composé III-V, tel que du GaN ou du GaAs, ou un substrat en ZnO. De préférence, le substrat 10 est un substrat de silicium monocristallin. De préférence, il s'agit d'un substrat semiconducteur compatible avec les procédés de fabrication mis en oeuvre en microélectronique. Le substrat 10 peut correspondre à une structure multicouches de type silicium sur isolant, également appelée SOI (acronyme anglais pour Silicon On Insulator).

Le substrat 10 peut être fortement dopé, faiblement dopé ou non dopé. Dans le cas où le substrat est fortement dopé, le substrat semiconducteur 10 peut être dopé de façon à baisser la résistivité électrique jusqu'à une résistivité proche de celle des métaux, de préférence inférieure à quelques mohm.cm. Le substrat 10 est, par exemple, un substrat 10 fortement dopé avec une concentration de dopants comprise entre 5*10¹⁶ atomes/cm³ et 2*10²⁰ atomes/cm³. Dans le cas où le substrat est faiblement dopé, par exemple avec une concentration de dopants inférieure ou égale à 5*10¹⁶ atomes/cm3, de préférence sensiblement égale à 10¹⁵ atomes/cm3, une région dopée du premier type de conductivité ou d'un deuxième type de conductivité, opposé au premier type, plus fortement dopée que le substrat peut être prévue qui s'étend dans le substrat 10 depuis la face 12 sous la couche de germination 16. Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). La face 12 du substrat 10 de silicium peut être une face (100).

La couche de germination 16 ou les plots de germination 62 sont en un matériau favorisant la croissance des fils 20 ou des pyramides 76, 78. A titre d'exemple, le matériau composant la couche de germination 16 ou les plots de germination 62 peut être un nitrure, un carbure ou un borure d'un métal de transition de la colonne IV, V ou VI du tableau périodique des éléments ou une combinaison de ces composés. A titre d'exemple, la couche de germination 16 peut être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci. La couche de germination 16 peut être dopée du même type de conductivité que le substrat 10.

La couche isolante 52 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'aluminium (Al₂O₃), en oxyde d'hafnium (HfO₂) ou en diamant.

La couche isolante 52 peut avoir une structure monocouche ou correspondre à un empilement de deux couches ou de plus de deux couches. Lorsque la couche isolante 52 correspond à un empilement d'au moins deux couches, la couche supérieure de l'empilement est de type isolante, par exemple en un matériau diélectrique. La ou les couches inférieures de l'empilement entre la couche de germination 16 et la couche supérieure isolante peuvent être en matériau diélectrique. A titre de variante, la ou les couches inférieures peuvent être en un matériau semiconducteur ou métallique, par exemple en nitrure d'aluminium (AlN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en tungstène (W) ou nitrure de tungstène (WN). Cette liste n'est pas limitative. On peut également former un « sandwich » de matériaux conducteurs et isolants. En particulier, la couche 52 peut comprendre un empilement de plusieurs couches, dont certaines peuvent être utilisées comme couches d'arrêt de gravure lors d'opérations de gravure. En particulier, la couche de germination 16 peut être recouverte d'une couche de protection ayant une hauteur comprise entre 30 nm et 50 nm.

Les fils 20 sont, au moins en partie, formés à partir d'au moins un matériau semiconducteur. Le matériau semiconducteur peut être du silicium, du germanium, du carbure de silicium, un composé III-V, un composé II-VI ou une combinaison d'au moins deux de ces composés.

Les fils 20 ou les pyramides 76, 78 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les fils 20 ou les pyramides 76, 78 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

La hauteur de chaque fil 20 peut être comprise entre 250 nm et 50 µm. Chaque fil 20 peut avoir une structure semiconductrice allongée selon un axe sensiblement perpendiculaire à la face 12. Chaque fil 20 peut avoir une forme générale cylindrique. Les axes de deux fils 20 adjacents peuvent être distants de 0,5 µm à 10 µm et de préférence de 1,5 µm à 4 µm. A titre d'exemple, les fils 20 peuvent être régulièrement répartis, notamment selon un réseau hexagonal.

La hauteur de chaque pyramide 76, 78 peut être comprise entre 100 nm et 25 µm. Chaque pyramide peut avoir une structure semiconductrice allongée selon un axe sensiblement perpendiculaire à la face 12. La base de chaque pyramide 76, 78 peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 4 µm. A titre d'exemple, les pyramides peuvent être régulièrement réparties, notamment selon un réseau hexagonal.

La coque 28 peut comprendre un empilement de plusieurs couches comprenant notamment :
- une couche active recouvrant la portion supérieure du fil 20 ou la pyramide 76, 78 associée ;
- une couche intermédiaire de type de conductivité opposé à la portion inférieure du fil 20 recouvrant la couche active ; et
- une couche de liaison recouvrant la couche intermédiaire et recouverte par l'électrode 30.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 3 à 20 nm (par exemple 6 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure de type N du fil 20 de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30. A titre d'exemple, la couche de liaison peut être dopée très fortement du type opposé à la portion inférieure du fil 20 ou de la pyramide 76, 78, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30 est adaptée à polariser la couche active de chaque fil 20 et à laisser passer le rayonnement électromagnétique émis par les diodes électroluminescentes DEL. Le matériau formant l'électrode 30 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 30 a une épaisseur comprise entre 5 nm et 200 nm, de préférence entre 20 nm et 50 nm.

La couche d'encapsulation 34 est réalisée en un matériau isolant au moins partiellement transparent. L'épaisseur maximale de la couche d'encapsulation 34 est comprise entre 250 nm et 50 µm de sorte que la couche d'encapsulation 34 recouvre complètement l'électrode 30 au sommet des diodes électroluminescentes DEL.

A titre de variante, une couche conductrice miroir, non représentée, recouvrant la couche d'électrode 30 entre les fils 20 ou entre les pyramides 76, 78 mais ne s'étendant pas sur les fils 20, peut être prévue. La couche conductrice miroir peut correspondre à une couche métallique, par exemple en aluminium, en argent, en cuivre ou en zinc.

Selon une autre variante, le dispositif optoélectronique 50 peut, en outre, comprendre une couche de luminophores, non représentée, prévue sur la couche d'encapsulation 34 ou confondue avec celle-ci.

Un mode de réalisation d'un procédé de fabrication du dispositif optoélectronique 50 représenté en figure 3 va être décrit en relation avec les figures 8A à 8C.

La figure 8A illustre la structure obtenue après la mise en oeuvre des étapes suivantes :
(1) Formation sur la face 12 du substrat 10 de la couche de germination 16.
   La couche de germination 16 peut être déposée par un procédé du type dépôt chimique en phase vapeur (CVD, sigle anglais pour Chemical Vapor Déposition) ou dépôt chimique en phase vapeur organométallique (MOCVD), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels l'évaporation ou la pulvérisation cathodique réactive peuvent être utilisés.
   Lorsque la couche de germination 16 est en nitrure d'aluminium, elle peut être sensiblement texturée et posséder une polarité préférentielle. La texturation de la couche 16 peut être obtenue par un traitement supplémentaire réalisé après le dépôt de la couche de germination. Il s'agit, par exemple, d'un recuit sous flux d'ammoniac (NH₃).
(2) Dépôt de la couche isolante 52, par exemple selon un dépôt conforme, notamment par CVD ; et
(3) Formation des ouvertures 54 dans la couche isolante 52, une seule ouverture 54 étant représentée en figure 8A. Il peut s'agir d'une gravure anisotrope par exemple une gravure ionique réactive ou RIE (sigle anglais pour Reactive Ion Etching) ou une gravure au plasma couplé par induction ou gravure ICP (sigle anglais pour inductively coupled plasma).
La figure 8B illustre la structure obtenue après l'étape suivante :
(4) Formation de germes dans chaque ouverture 54, trois germes 80, 82, 84 étant représentés à titre d'exemple en figure 8B.

Le procédé de formation des germes 80, 82, 84 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de formation de germes peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation, la température dans le réacteur à l'étape (4) est inférieure ou égale à 1000 °C, de préférence inférieure ou égale à 820°C.

Selon un mode de réalisation, le rapport entre le flux du gaz précurseur de l'élément du groupe V et le flux du gaz précurseur de l'élément du groupe III, ou rapport V/III, à l'étape (4) est supérieur ou égal à 1000, de préférence supérieur ou égal à 5000.

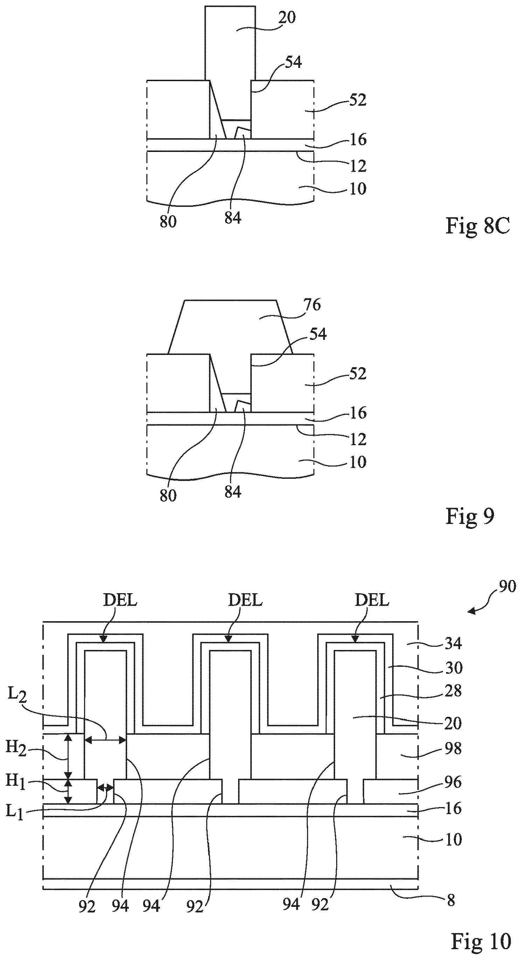

La figure 8C illustre la structure obtenue après l'étape suivante :
(5) Croissance d'un fil 20 dans chaque ouverture 54.

Le procédé de croissance des fils 20 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils 20 peut comprendre l'injection dans un réacteur d'un précurseur d'un élément du groupe III et d'un précurseur d'un élément du groupe V.

De préférence, la température dans le réacteur lors de l'étape (4) est inférieure à la température dans le réacteur lors de l'étape (5).

De préférence, le rapport V/III à l'étape (4) est supérieur au rapport V/III à l'étape (5).

Selon un mode de réalisation, la température dans le réacteur à l'étape (5) est supérieure ou égale à 950 °C, de préférence supérieure ou égale à 1000 °C.

Selon un mode de réalisation, le rapport V/III à l'étape (5) est inférieur ou égal à 100, de préférence inférieur ou égal à 50.

Selon un mode de réalisation de l'invention, à l'étape (4) et dans une première phase de croissance des fils du composé III-V à l'étape (5), un précurseur d'un élément supplémentaire est ajouté en excès en plus des précurseurs du composé III-V. L'élément supplémentaire peut être le silicium (Si). Un exemple de précurseur du silicium est le silane (SiH₄).

La présence de silane parmi les gaz précurseurs entraîne l'incorporation de silicium au sein du composé GaN. On obtient ainsi une portion inférieure du fil 20 dopée de type N. En outre, ceci se traduit par la formation d'une couche de nitrure de silicium, non représentée, qui recouvre le pourtour de la portion inférieure du fil, à l'exception du sommet au fur et à mesure de la croissance de la portion inférieure du fil.

Selon un mode de réalisation de l'invention, dans une deuxième phase de croissance des fils du composé III-V, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure du fil ainsi obtenue peut être dopée de type N en raison de la diffusion dans cette portion active de dopants provenant des portions passivées adjacentes ou en raison du dopage résiduel du GaN.

Comme cela apparaît sur la figure 8C, la hauteur H suffisamment élevée de la couche isolante 52 entraîne que seul le microfil dont l'axe de croissance est sensiblement parallèle à l'axe de l'ouverture 54 parvient à croître à l'extérieur de l'ouverture 54.

Les étapes ultérieures du procédé de fabrication du dispositif optoélectronique 50 sont les suivantes :
(6) Formation par épitaxie, pour chaque fil 20, des couches composant la coque 28. Le dépôt des couches composant la coque 28 ne se produit que sur la portion du fil 20 hors de l'ouverture 54 de la couche isolante 52.
(7) Formation de la deuxième électrode 30, par exemple par dépôt conforme.
(8) Formation de la couche d'encapsulation 34. Lorsque la couche d'encapsulation 34 est en silicone, la couche d'encapsulation 34 peut être déposée par un procédé de dépôt à la tournette, par un procédé d'impression par jet ou par un procédé de sérigraphie. Lorsque la couche d'encapsulation 34 est un oxyde, elle peut être déposée par CVD.
(9) Formation par dépôt de la première électrode 8, recouvrant la face inférieure 11 du substrat 10.
(10) Découpe du substrat 10 pour séparer les dispositifs optoélectroniques.

A titre d'exemple, l'étape (9) décrite précédemment peut être réalisée entre l'étape (7) et l'étape (8) décrites précédemment ou entre l'étape (6) et l'étape (7) décrites précédemment.

Un mode de réalisation d'un procédé de fabrication du dispositif optoélectronique 60, représenté en figure 4, comprend les étapes (1) à (10) décrites précédemment à la différence que l'étape (1) est remplacée par l'étape (11) suivante :
(11) Formation de la couche de nucléation 16 selon l'étape (1) décrite précédemment et gravure de la couche de germination 16 pour former les plots de germination 62. La gravure de la couche de germination 16 peut être réalisée par gravure sèche, par exemple une gravure ionique réactive ou RIE (sigle anglais pour Reactive Ion Etching) ou une gravure au plasma couplé par induction ou gravure ICP (sigle anglais pour inductively coupled plasma).

Un mode de réalisation d'un procédé de fabrication du dispositif optoélectronique 70, représenté en figure 5, comprend les étapes (1) à (10) décrites précédemment à la différence que l'étape (1) est remplacée par l'étape (12) suivante :
(12) Formation des plots de nucléation 62 selon l'étape (11) décrite précédemment et protection des portions de la face 12 du substrat 10 non recouvertes des plots de germination 62 et, éventuellement, des flancs latéraux des plots de germination 62 pour éviter la croissance ultérieure de fils sur ces portions. Selon un exemple, ceci peut être réalisé par la formation d'un masque au sommet de chaque plot de germination 62 et par une étape d'oxydation qui entraîne la formation des régions diélectriques 72 en surface du substrat 10 entre les plots de germination 62 et des régions diélectriques 73 sur les flancs latéraux de chaque plot de germination 62. Selon un autre exemple, ceci peut être réalisé par une étape de nitruration de la surface du substrat 10 et des plots de germination 62 qui entraîne la formation des régions diélectriques 72 en surface du substrat 10 entre les plots de germination 62.

Un mode de réalisation d'un procédé de fabrication des dispositifs optoélectroniques 75 ou 77, représentés respectivement en figure 6 ou 7, comprend les étapes (1) à (10) décrites précédemment à la différence que l'étape (5) est remplacée par l'étape (13) suivante :
(13) Croissance des pyramides 76, 78 depuis chaque ouverture 54. Le procédé de croissance des pyramides 76, 78 peut être un procédé du type CVD, MOCVD, MBE, GSMBE, PAMBE, ALE, HVPE, ALD. En outre, des procédés électrochimiques peuvent être utilisés, par exemple, le procédé CBD, les procédés hydrothermiques, la pyrolyse d'aérosol liquide ou l'électrodépôt. Les conditions de croissances sont choisies afin de faire croître les structures cristallines préférentiellement sous forme de pyramides et non de fils.

La figure 9 représente la structure obtenue à l'étape (13) au cours de la croissance de la pyramide 76.

Le remplacement de l'étape (1) par l'étape (11) décrite précédemment peut être appliqué également pour les structures pyramidales ou pyramidales tronquées.

La figure 10 est une vue en coupe, partielle et schématique, d'un mode de réalisation d'un dispositif optoélectronique 90 à diodes électroluminescentes.

Le dispositif optoélectronique 90 comprend les mêmes éléments que le dispositif optoélectronique 50 représenté en figure 3 à la différence que chaque ouverture 54 est remplacée par une ouverture comprenant deux parties d'ouverture successives 92 et 94 ayant des dimensions différentes. Les deux parties d'ouverture 92, 94 sont de préférence coaxiales. A titre d'exemple, la couche isolante 52 est remplacée par un empilement de deux couches isolantes 96 et 98. La couche isolante 96 recouvre la couche de nucléation 16 et comprend les ouvertures 92. Chaque ouverture 92 expose une portion de la couche de nucléation 16. Chaque ouverture 92 a une hauteur H₁ et un diamètre L₁, de préférence sensiblement constant sur toute la hauteur H₁. La couche isolante 98 recouvre la couche isolante 96 et comprend les ouvertures 94. Chaque ouverture 94 expose l'une des ouvertures 92 et une portion de la couche isolante 96 autour de l'ouverture 92. Chaque ouverture 94 a une hauteur H₂ et un diamètre L₂, de préférence sensiblement constant sur toute la hauteur H₂.

Dans le présent mode de réalisation, le diamètre L₁ est strictement inférieur au diamètre L₂.

A titre d'exemple, la hauteur H₁ de chaque ouverture 92, c'est-à-dire l'épaisseur de la couche isolante 96, est comprise entre 30 nm et 500 nm, de préférence entre 100 nm et 300 nm. A titre d'exemple, le diamètre L₁ de chaque ouverture 92 est compris entre 30 nm et 1 µm, de préférence entre 100 nm et 600 nm. Le rapport F₁ entre la hauteur H₁ et le diamètre L₁ est compris entre 0,1 et 4, de préférence entre 0,75 et 1,5.

A titre d'exemple, la hauteur H₂ de chaque ouverture 94, c'est-à-dire l'épaisseur de la couche isolante 98, est comprise entre 200 nm et 2000 nm, de préférence entre 250 nm et 500 nm. A titre d'exemple, le diamètre L₂ de chaque ouverture 94 est compris entre 50 nm et 2 µm, de préférence entre 150 nm et 800 nm. Le rapport F₂ entre la hauteur H₂ et le diamètre L₂ est compris entre 0,1 et 4, de préférence entre 0,75 et 1,5.

Les couches isolantes 96, 98 peuvent être composées du même matériau ou de matériaux différents. A titre d'exemple, l'une des couches 96, 98 est en oxyde de silicium (SiO₂) et l'autre couche est en nitrure de silicium (SiₓN_{y}, où x est environ égal à 3 et y est environ égal à 4, par exemple du Si₃N₄). A titre de variante, les ouvertures 92, 94 sont formées dans une seule couche isolante.

A titre de variante, la couche 96 n'est pas réalisée avec un matériau isolant mais avec un matériau semiconducteur, notamment AlN, ou métallique, notamment Ti, TiN, Ta, TaN, Hf, HfN, W, Mo par exemple avec l'un des matériaux décrits précédemment pour les couches inférieures de la couche 52.

Le diamètre L₁ de l'ouverture 92 est sélectionné pour favoriser la croissance d'un germe unique dans l'ouverture 92. Le diamètre L₂ de l'ouverture 94 est sélectionné en fonction du diamètre souhaité du fil 20.

Un mode de réalisation d'un procédé de fabrication du dispositif optoélectronique 90 comprend les étapes (1) à (10) décrites précédemment à la différence que les étapes (2) et (3) sont remplacées par l'étape (14) suivante :
(14) Dépôt successif des couches isolantes 96 et 98 et formation des ouvertures 94 et des ouvertures 92.

Lorsque les matériaux composant les couches isolantes 96 et 98 sont différents, les ouvertures 94 peuvent être formées dans la couche isolante 98 par une gravure qui est sélective par rapport au matériau formant la couche isolante 96. Lorsque les matériaux composant les couches isolantes 96 et 98 sont les mêmes, la profondeur des ouvertures 94 peut être commandée par la durée de la gravure.

Une variante de cette méthode consiste à d'abord déposer la couche 96 puis à réaliser chaque ouverture 92. Après cette étape, on dépose la couche isolante 98 qui peut éventuellement venir remplir les ouvertures 92. On réalise ensuite les ouvertures 94 en utilisant une gravure sélective par rapport au matériau formant la couche isolante 98.

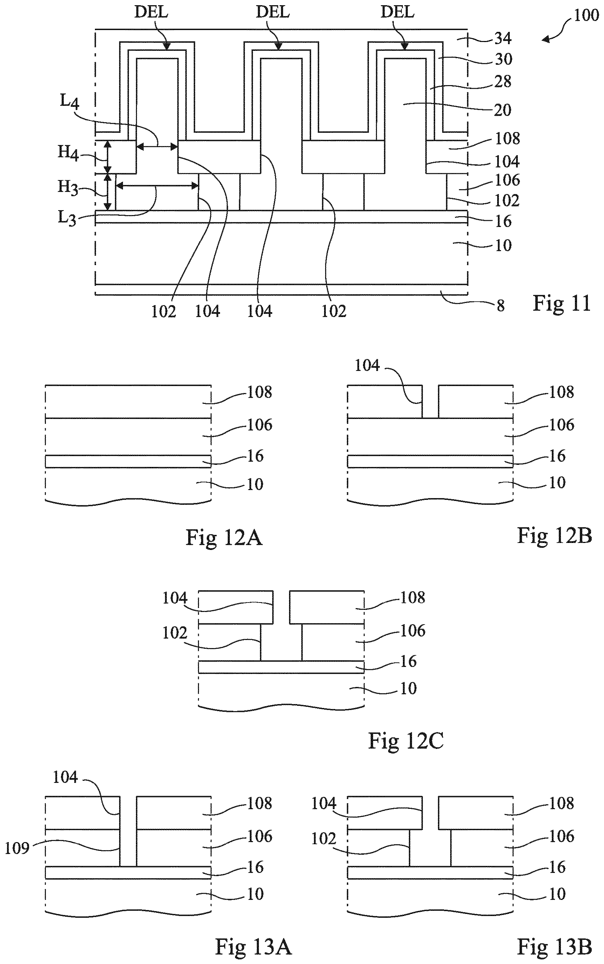

La figure 11 est une vue en coupe, partielle et schématique, d'un mode de réalisation d'un dispositif optoélectronique 100 à diodes électroluminescentes.

Le dispositif optoélectronique 100 comprend les mêmes éléments que le dispositif optoélectronique 50 représenté en figure 3 à la différence que chaque ouverture 54 est remplacée par une ouverture comprenant deux parties successives 102 et 104 ayant des dimensions différentes. A titre d'exemple, la couche isolante 52 est remplacée par un empilement de deux couches 106 et 108, la couche 106 recouvrant la couche de nucléation 16 et comprenant les ouvertures 102. La couche 108 est en un matériau isolant électriquement. Chaque ouverture 102 expose une portion de la couche de nucléation 16. Chaque ouverture 102 a une hauteur H₃ et un diamètre L₃, de préférence sensiblement constant sur toute la hauteur H₃. La couche isolante 108 comprend les ouvertures 104, recouvre la couche isolante 106 et est en porte-à-faux avec ladite couche isolante 106 au niveau de chaque ouverture 102. Chaque ouverture 104 a une hauteur H₄ et un diamètre L₄.

Dans le présent mode de réalisation, le diamètre L₄ est strictement inférieur au diamètre L₃.

A titre d'exemple, la hauteur H₃ de chaque ouverture 102, c'est-à-dire l'épaisseur de la couche isolante 106, est comprise entre 30 nm et 500 nm, de préférence entre 100 nm et 300 nm. A titre d'exemple, le diamètre L₃ de chaque ouverture 102 est compris entre 100 nm et 2 µm, de préférence entre 200 nm et 800 nm. Le rapport F₃ entre la hauteur H₃ et le diamètre L₃ est compris entre 0,1 et 5, de préférence entre 0,4 et 1,5.

A titre d'exemple, la hauteur H₄ de chaque ouverture 104, c'est-à-dire l'épaisseur de la couche isolante 108, est comprise entre 50 nm et 500 nm, de préférence entre 100 nm et 300 nm. A titre d'exemple, le diamètre L₄ de chaque ouverture 104 est compris entre 30 nm et 1 µm, de préférence entre 100 nm et 400 nm. Le rapport F₄ entre la hauteur H₄ et le diamètre L₄ est compris entre 0,1 et 2, de préférence entre 0,5 et 2,0.

Selon un mode de réalisation, les couches isolantes 106, 108 sont composées de matériaux différents. A titre d'exemple, l'une des couches 106, 108 est en oxyde de silicium (SiO₂) et l'autre couche est en nitrure de silicium (SiₓN_{y}, où x est environ égal à 3 et y est environ égal à 4, par exemple du Si₃N₄). Selon un autre mode de réalisation, la couche 106 est en nitrure d'aluminium et la couche 108 est en nitrure de silicium.

Le diamètre L₃ de l'ouverture 102 est sélectionné pour rendre sensiblement certain qu'au moins un germe va croître dans l'ouverture 102 sur la couche de nucléation 16. Le diamètre L₄ de l'ouverture 94 est sélectionné en fonction du diamètre souhaité du fil 20 et est suffisamment étroit pour sélectionner le fil issu d'un seul germe dans le cas où plusieurs germes se forment dans l'ouverture 102.

De façon avantageuse, les dimensions de l'ouverture 102 sont un paramètre de commande de la formation des germes et les dimensions de l'ouverture 104 sont un paramètre de commande de la sélection d'un fil unique. De ce fait, les paramètres de commande de la formation des germes et de sélection d'un fil unique ne dépendent pas d'une seule ouverture et peuvent être ajustés indépendamment.

Un mode de réalisation d'un procédé de fabrication du dispositif optoélectronique 100 représenté en figure 11 va être décrit en relation avec les figures 12A à 12C. Le mode de réalisation est décrit dans le cas où les couches 106 et 108 sont des couches isolantes. Néanmoins, ce mode de réalisation peut être appliqué dans le cas où la couche 106 n'est pas de nature isolante électriquement. Ce mode de réalisation comprend les étapes (1) à (10) décrites précédemment à la différence que les étapes (2) et (3) sont remplacées par les étapes suivantes :
(15) Dépôt successif des couches isolantes 106 et 108 (figure 12A).
(16) Formation de l'ouverture 104 par une gravure anisotrope (figure 12B) du matériau de la couche isolante 108, cette gravure étant sélective ou non par rapport au matériau de la couche isolante 106. Dans le cas où cette gravure n'est pas sélective par rapport au matériau de la couche isolante 106, la gravure est terminée après un temps déterminé.
(17) Formation de l'ouverture 102 par une gravure isotrope (figure 12C), depuis l'ouverture 104, du matériau de la couche isolante 106, cette gravure étant sélective par rapport au matériau de la couche isolante 108.

Des exemples de gravures isotropes de l'oxyde de silicium ou du nitrure de silicium sont l'acide fluorhydrique (HF), l'acide fluorhydrique tamponné (BHF, acronyme anglais pour Buffered HF), du fluorure d'ammonium (NH₄F) ou une solution de BOE (acronyme anglais pour Buffered Oxide Etch).

Des exemples de gravures anisotropes de l'oxyde de silicium ou du nitrure de silicium sont du trifluorométhane (CHF₃), du tétrafluorure de carbone (CF₄), de l'hexafluorure de soufre (SF₆) ou du trifluorure d'azote (NF₃), auxquels peuvent être ajoutés des gaz porteurs inertes ou presque inertes tels que le dihydrogène, l'hélium, l'argon ou le dioxygène, de manière à ajuster les vitesses de gravure.

A titre d'exemple, le H₃PO₄ peut être utilisé pour graver sélectivement l'oxyde de silicium par rapport au nitrure de silicium.

A titre d'exemple, un plasma de fluor-carbone tel que du C₅F₈+O₂+Ar peut être utilisé pour graver du nitrure de silicium sélectivement par rapport à l'oxyde de silicium.

Un autre mode de réalisation d'un procédé de fabrication du dispositif optoélectronique 100 représenté en figure 11 va être décrit en relation avec les figures 13A et 13B. Ce mode de réalisation comprend les étapes (1) à (10) décrites précédemment à la différence que les étapes (2) et (3) sont remplacées par les étapes suivantes :
(18) Dépôt successif des couches isolantes 106 et 108.
(19) Formation de l'ouverture 104 par une gravure anisotrope du matériau de la couche isolante 108 puis d'une ouverture 109 dans le prolongement de l'ouverture 104 par une gravure anisotrope du matériau de la couche isolante 106 (figure 13A). La gravure utilisée n'est pas sélective par rapport aux matériaux composant les couches isolantes 106 et 108. Il s'agit, par exemple, d'une gravure du type CHF₃+O₂ ou CF₄+H₂.
(20) Formation de l'ouverture 102 par une gravure isotrope (figure 13B), depuis l'ouverture 109, du matériau de la couche isolante 106, cette gravure étant sélective par rapport au matériau de la couche isolante 108.

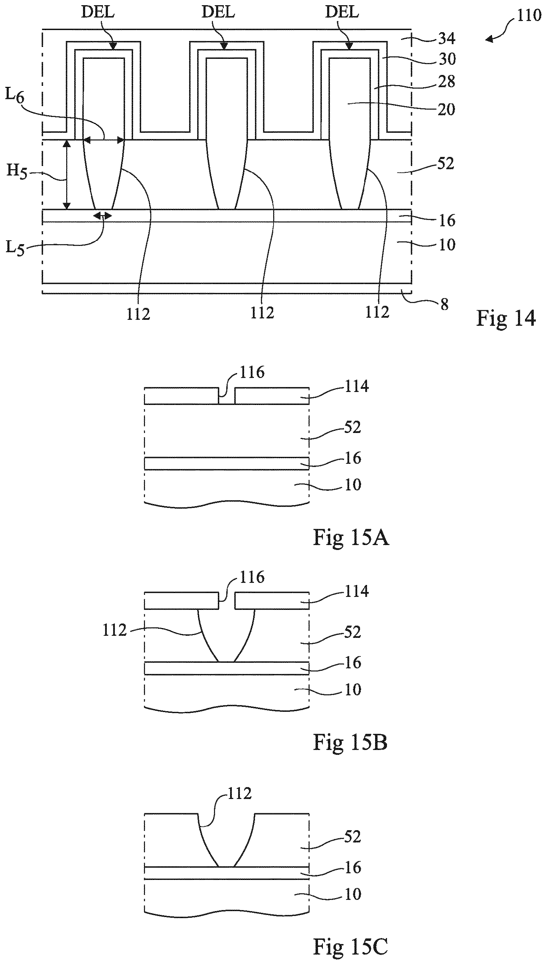

La figure 14 est une vue en coupe, partielle et schématique, d'un mode de réalisation d'un dispositif optoélectronique 110 à diodes électroluminescentes.

Le dispositif optoélectronique 110 comprend les mêmes éléments que le dispositif optoélectronique 50 représenté en figure 3 à la différence que chaque ouverture 54 est remplacée par une ouverture 112 ayant une hauteur H₅ ayant un diamètre qui augmente en fonction de la hauteur lorsqu'on s'éloigne du substrat 10. On appelle L₅ le plus petit diamètre de l'ouverture 112 et L₆ le plus grand diamètre de l'ouverture 112.

A titre d'exemple, la hauteur H₅ de chaque ouverture 112 est comprise entre 30 nm et 1 µm, de préférence entre 200 nm et 600 nm. A titre d'exemple, le diamètre L₅ est compris entre 30 nm et 600 nm, de préférence entre 100 nm et 400 nm. A titre d'exemple, le diamètre L₆ est compris entre 50 nm et 2 µm, de préférence entre 350 nm et 800 nm. Le rapport F5 entre la hauteur H₅ et le diamètre L₅ est compris entre 0,5 et 10, de préférence entre 0,75 et 4.

Le diamètre L₅ à la base de l'ouverture 112 est sélectionné pour favoriser la croissance d'un germe unique sur la portion de la couche de germination 16 exposée par l'ouverture 112. Le diamètre L₆ au sommet de l'ouverture 112 est sélectionné en fonction du diamètre souhaité du fil 20.

Un mode de réalisation d'un procédé de fabrication du dispositif optoélectronique 110 de la figure 14 va être décrit en relation avec les figures 15A à 15C. Ce mode de réalisation comprend les étapes (1) à (10) décrites précédemment à la différence que les étapes (2) et (3) sont remplacées par les étapes suivantes :
(21) Dépôt successif de la couche isolante 52 et d'une couche de résine 114 et gravure d'une ouverture 116 dans la couche de résine exposant une portion de la couche isolante 52 (figure 15A) .
(22) Formation de l'ouverture 112 par une gravure partiellement anisotrope (figure 15B) du matériau de la couche isolante 52. A titre d'exemple, la gravure peut être une gravure du type RIE (acronyme anglais pour reactive ion etching). Le caractère anisotrope peut être plus important au début de la gravure qu'à la fin de la gravure.
(23) Retrait de la couche de résine 114 (figure 15C).

A titre de variante, la couche 114 peut être un masque dur par exemple en un matériau diélectrique, par exemple de l'oxyde de silicium SiO₂ ou du nitrure de silicium SiN.

Dans les modes de réalisation décrits précédemment en relation avec les figures 10 et 11, la formation des germes et la croissance des fils sont réalisées après la formation des ouvertures 92, 94, 102, 104 dans les couches 96, 98, 106, 108 recouvrant la couche de nucléation 16. Toutefois, à titre de variante, l'étape de formation des germes et une partie de la croissance des fils dans les ouvertures 92, 102 peuvent être réalisées avant l'étape de formation des couches isolantes 98, 108 et l'étape de formation des ouvertures 94, 104.

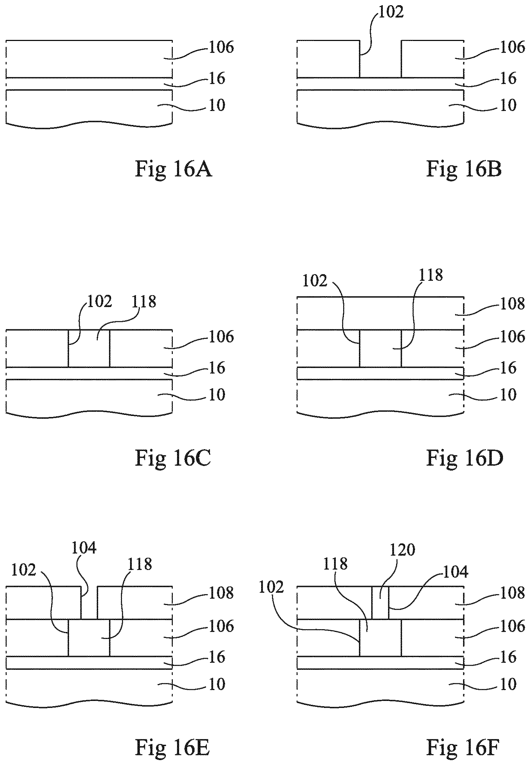

Un mode de réalisation d'un tel procédé de fabrication du dispositif optoélectronique 100 représenté en figure 8 va être décrit en relation avec les figures 16A à 16F. Ce mode de réalisation comprend les étapes (1) à (10) décrites précédemment à la différence que les étapes (2) et (3) sont remplacées par les étapes suivantes :
(24) Dépôt de la couche 106 sur la couche de germination 16 (figure 16A).
(25) Formation des ouvertures 102 dans la couche 106 (figure 16B).
(26) Formation de germes dans chaque ouverture 102 et croissance d'un ou de plusieurs fils dans chaque ouverture 102 de façon à obtenir une portion 118 semiconductrice remplissant sensiblement complètement l'ouverture 102 (figure 16C).
(27) Dépôt de la couche isolante 108 sur la couche isolante 106 et sur les portions semiconductrices 118 (figure 16D) .
(28) Formation des ouvertures 104 dans la couche 108 pour exposer une partie des portions semiconductrices 118 (figure 16E) .
(29) Croissance d'un fil dans chaque ouverture 104 depuis la portion semiconductrice 118, une portion semiconductrice 120 étant représentée dans chaque ouverture 104 (figure 16F).

Les modes de réalisation décrits précédemment en relation avec les figures 7, 8 et 11 ont été décrits dans le cas d'une couche de germination 16 recouvrant le substrat 10. Toutefois, ces modes de réalisation peuvent également être mis en oeuvre en utilisant, à la place de la couche de germination 16, des plots de germination 62 comme cela a été décrit en relation avec la figure 4 ou en utilisant des blocs isolants 71, éventuellement formés d'un empilement de deux blocs isolants comme cela a été décrit en relation avec la figure 5.

Les modes de réalisation décrits précédemment en relation avec les figures 10, 11 et 14 ont été décrits dans le cas d'une croissance ultérieure d'éléments semiconducteurs de type microfil ou nanofil. Ces modes de réalisation peuvent être également appliqués dans le cas de croissance d'éléments semiconducteurs de type pyramide ou pyramide tronquée.

Dans les modes de réalisation décrits précédemment, la coque 28 recouvre chaque fil 20 jusqu'à la couche isolante 52, 98 ou 108. Toutefois, à titre de variante, il peut être prévu une couche isolante qui recouvre une partie des flancs latéraux de chaque fil 20 sur une partie de la hauteur des fils 20 en dehors des ouvertures 54, 94, 104, 112. La coque 28 recouvre alors les flancs latéraux des fils 20 sauf aux emplacements où cette couche isolante est présente. Cette couche isolante peut, en outre, recouvrir une partie de la coque 28.

Des modes de réalisation particuliers de la présente invention ont été décrits. Bien que des modes de réalisation aient été décrits pour un dispositif optoélectronique pour lequel la coque 28 recouvre le sommet du fil 20 associé et une partie des flancs latéraux du fil 20, la coque peut n'être prévue qu'au sommet du fil 20.

## Revendications

1. Dispositif optoélectronique (50 ; 60 ; 70 ; 75 ; 77 ; 90 ; 100 ; 110) comprenant des éléments semiconducteurs (20 ; 76 ; 78), chaque élément semiconducteur reposant sur un support (16 ; 62) au travers d'une ouverture (54 ; 92, 94 ; 102, 104 ; 112) formée dans une portion (52 ; 71 ; 96, 98 ; 106, 108) recouvrant au moins partiellement le support et dont au moins une première partie est isolante, **caractérisé en ce que** la hauteur (H) de l'ouverture est supérieure ou égale à 200 nm et inférieure ou égale à 3000 nm et **en ce que** le rapport entre la hauteur (H) et le plus petit diamètre de l'ouverture (L ; L₂ ; L₄ ; L₅) est supérieur ou égal à 1 et inférieur ou égal à 10.

2. Dispositif optoélectronique selon la revendication 1, dans lequel les éléments semiconducteurs (20 ; 76 ; 78) sont des nanofils, des microfils et/ou des structures pyramidales de taille nanométrique ou micrométrique.

3. Dispositif optoélectronique selon la revendication 1 ou 2, dans lequel le diamètre moyen (L) de l'ouverture (54) est constant sur toute la hauteur de la portion (52 ; 71).

4. Dispositif optoélectronique selon la revendication 1 ou 2, dans lequel le diamètre moyen de l'ouverture (112) diminue de façon continue depuis le sommet de l'ouverture jusqu'à la base de l'ouverture.

5. Dispositif optoélectronique selon la revendication 1 ou 2, dans lequel l'ouverture comprend successivement depuis la base de l'ouverture une première partie (92 ; 102) et une deuxième partie (94 ; 104), le diamètre moyen de la première partie étant constant sur toute la hauteur de la première partie et le diamètre moyen de la deuxième partie étant constant sur toute la hauteur de la deuxième partie et différent du diamètre moyen sur la première partie.

6. Dispositif optoélectronique selon la revendication 5, dans lequel le diamètre moyen (L₁) de la première partie (92) est strictement inférieur au diamètre moyen (L₂) de la deuxième partie (94).

7. Dispositif optoélectronique selon la revendication 5, dans lequel le diamètre moyen (L₃) de la première partie (102) est strictement supérieur au diamètre moyen (L₄) de la deuxième partie (104).

8. Dispositif optoélectronique selon l'une quelconque des revendications 1 à 7, dans lequel la première partie de la portion (96, 98 ; 106, 108) comprend au moins l'un des matériaux parmi les oxydes de silicium, les nitrures de silicium et les oxydes d'aluminium.

9. Dispositif optoélectronique selon l'une quelconque des revendications 1 à 8, dans lequel au moins une deuxième partie de la portion (96, 98 ; 106, 108) comprend au moins un matériau non isolant électriquement.

10. Dispositif optoélectronique selon l'une quelconque des revendications 1 à 7, dans lequel la deuxième partie de la portion (96, 98 ; 106, 108) comprend au moins l'un des matériaux choisis parmi le groupe comprenant AlN, Ti, TiN, Ta, TaN, Hf, HfN, W, WN, Mo.

11. Dispositif optoélectronique selon l'une quelconque des revendications 1 à 10, dans lequel chaque élément semiconducteur (20 ; 76, 77) est majoritairement en un composé III-V.

12. Dispositif optoélectronique selon la revendication 11, dans lequel chaque élément semiconducteur (20 ; 76, 78) comprend majoritairement du nitrure de gallium.

13. Procédé de fabrication d'un dispositif optoélectronique comprenant les étapes suivantes :
former, sur un support (16 ; 62), une portion (52 ; 71 ; 96, 98 ; 106, 108) recouvrant au moins partiellement le support et dont au moins une première partie est isolante ;
former une ouverture (54 ; 92, 94 ; 102, 104 ; 112) traversant la portion, la hauteur (H) de l'ouverture étant supérieure ou égale à 200 nm et inférieure ou égale à 3000 nm et le rapport entre la hauteur et le diamètre moyen de l'ouverture au sommet de la portion étant supérieur ou égal à 1 et inférieur ou égal à 10 ; et
faire croître dans chaque ouverture un élément semiconducteur (20 ; 76, 77) reposant sur le support.

14. Procédé selon la revendication 13, dans lequel la hauteur (H) de la portion (52 ; 71 ; 96, 98 ; 106, 108) est supérieure ou égale à 100 nm et inférieure ou égale à 1000 nm.

15. Procédé selon la revendication 14, dans lequel la formation de la portion (52 ; 71 ; 96, 98 ; 106, 108) comprend les étapes suivantes :
déposer une première couche isolante (106) comprenant un premier matériau isolant ;
déposer une deuxième couche isolante (108) comprenant un deuxième matériau isolant différent du premier matériau isolant ;
former une première partie (104) de l'ouverture dans la première couche isolante ;
former une deuxième partie (102) de l'ouverture dans la deuxième partie de la couche isolante, le diamètre moyen de la première partie étant différent du diamètre moyen de la deuxième partie ; et
faire croître dans chaque première et deuxième parties de l'ouverture un élément semiconducteur (20) reposant sur le support.

16. Procédé selon la revendication 14, dans lequel la formation de la portion (52 ; 71 ; 96, 98 ; 106, 108) comprend les étapes suivantes :
déposer une première couche isolante (96) comprenant un premier matériau isolant ;
former une première partie (92) de l'ouverture dans la première couche isolante ;
déposer une deuxième couche isolante (98) comprenant un deuxième matériau isolant différent du premier matériau isolant ;
former une deuxième partie (94) de l'ouverture dans la deuxième partie de la couche isolante, le diamètre moyen de la première partie étant différent du diamètre moyen de la deuxième partie ; et
faire croître dans chaque première et deuxième parties de l'ouverture un élément semiconducteur (20) reposant sur le support.

## Patentansprüche

1. Optoelektronische Vorrichtung (50; 60; 70; 75; 77; 90; 100; 110) mit Halbleiterelementen (20; 76; 78), wobei jedes Halbleiterelement auf einem Träger (16; 62) ruht, und zwar durch eine Öffnung (54; 92, 94; 102, 104; 112) hindurch, die in einem Teil (52; 71; 96, 98; 106, 108) ausgebildet ist, der den Träger wenigstens teilweise abdeckt und von dem wenigstens ein erster Teil isolierend ist, **dadurch gekennzeichnet, dass** die Höhe (H) der Öffnung größer oder gleich 200 nm und kleiner oder gleich 3000 nm ist und dass das Verhältnis der Höhe (H) zum kleinsten Durchmesser der Öffnung (L; L2; L4; L5) größer oder gleich 1 und kleiner oder gleich 10 ist.

2. Optoelektronische Vorrichtung nach Anspruch 1, wobei die Halbleiterelemente (20; 76; 78) Nanodrähte, Mikrodrähte und/oder pyramidenförmige Strukturen im Nano- oder Mikrometerbereich sind.

3. Optoelektronische Vorrichtung nach Anspruch 1 oder 2, wobei der durchschnittliche Durchmesser (L) der Öffnung (54) über die gesamte Höhe des Teils (52; 71) konstant ist.

4. Optoelektronische Vorrichtung nach Anspruch 1 oder 2, wobei der durchschnittliche Durchmesser der Öffnung (112) von der Oberseite der Öffnung bis zur Basis der Öffnung kontinuierlich abnimmt.

5. Optoelektronische Vorrichtung nach Anspruch 1 oder 2, wobei die Öffnung ausgehend von der Basis der Öffnung aufeinanderfolgend Folgendes aufweist, einen ersten Teil (92; 102) und einen zweiten Teil (94; 104), wobei der durchschnittliche Durchmesser des ersten Teils über die gesamte Höhe des ersten Teils konstant ist und der durchschnittliche Durchmesser des zweiten Teils über die gesamte Höhe des zweiten Teils konstant ist und sich von dem durchschnittlichen Durchmesser des ersten Teils unterscheidet.

6. Optoelektronische Vorrichtung nach Anspruch 5, wobei der durchschnittliche Durchmesser (L1) des ersten Teils (92) kleiner als der durchschnittliche Durchmesser (L2) des zweiten Teils (94) ist.

7. Optoelektronische Vorrichtung nach Anspruch 5, wobei der durchschnittliche Durchmesser (L3) des ersten Teils (102) größer als der durchschnittliche Durchmesser (L4) des zweiten Teils (104) ist.

8. Optoelektronische Vorrichtung nach einem der Ansprüche 1 bis 7, wobei der erste Teil des Teils (96, 98; 106, 108) wenigstens eines der folgenden Materialien aufweist, Siliziumoxide, Siliziumnitride und Aluminiumoxide.

9. Optoelektronische Vorrichtung nach einem der Ansprüche 1 bis 8, wobei wenigstens ein zweiter Teil des Teils (96, 98; 106, 108) wenigstens ein Material aufweist, das nicht elektrisch isolierend ist.

10. Optoelektronische Vorrichtung nach einem der Ansprüche 1 bis 7, wobei der zweite Teil des Teils (96, 98; 106, 108) wenigstens eines der Materialien aufweist, das aus der folgenden Gruppe ausgewählt ist, die AlN, Ti, TiN, Ta, TaN, Hf, HfN, W, WN, Mo aufweist.

11. Optoelektronische Vorrichtung nach einem der Ansprüche 1 bis 10, wobei jedes Halbleiterelement (20; 76, 77) hauptsächlich aus einer III-V-Verbindung hergestellt ist.

12. Optoelektronische Vorrichtung nach Anspruch 11, wobei jedes Halbleiterelement (20; 76, 78) hauptsächlich Galliumnitrid aufweist.

13. Verfahren zur Herstellung einer optoelektronischen Vorrichtung, das die folgenden Schritte aufweist:
Ausbilden, auf einem Träger (16; 62), eines Teils (52; 71; 96, 98; 106, 108), der den Träger wenigstens teilweise abdeckt und wenigstens einen ersten isolierenden Teil aufweist;
Ausbilden einer Öffnung (54; 92, 94; 102, 104; 112), durch das Teil hindurch, wobei die Höhe (H) der Öffnung größer oder gleich 200 nm und kleiner oder gleich 3000 nm ist und das Verhältnis der Höhe zum durchschnittlichen Durchmesser der Öffnung an der Oberseite des Teils größer oder gleich 1 und kleiner oder gleich 10 ist; und
Aufwachsen, in jeder Öffnung, eines Halbleiterelements (20; 76, 77), das auf dem Träger aufliegt.

14. Verfahren nach Anspruch 13, wobei die Höhe (H) des Teils (52; 71; 96, 98; 106, 108) größer oder gleich 100 nm und kleiner oder gleich 1.000 nm ist.

15. Verfahren nach Anspruch 14, wobei das Ausbilden des Teils (52; 71; 96, 98; 106, 108) die folgenden Schritte aufweist:
Abscheiden einer ersten Isolierschicht (106), die ein erstes Isoliermaterial aufweist;
Abscheiden einer zweiten Isolierschicht (108), die ein zweites, vom ersten Isoliermaterial unterschiedliches Isoliermaterial aufweist;
Ausbilden eines ersten Teils (104) der Öffnung in der ersten Isolierschicht;
Ausbilden eines zweiten Teils (102) der Öffnung in dem zweiten Teil der Isolierschicht, wobei sich der durchschnittliche Durchmesser des ersten Teils von dem durchschnittlichen Durchmesser des zweiten Teils unterscheidet; und
Aufwachsen, in jedem ersten und zweiten Teil der Öffnung, eines Halbleiterelements (20), das auf dem Träger aufliegt.

16. Verfahren nach Anspruch 14, wobei das Ausbilden des Teils (52; 71; 96, 98; 106, 108) die folgenden Schritte aufweist:
Abscheiden einer ersten Isolierschicht (96), die ein erstes Isoliermaterial aufweist;
Ausbilden eines ersten Teils (92) der Öffnung in der ersten Isolierschicht;
Abscheiden einer zweiten Isolierschicht (98), die ein zweites, vom ersten Isoliermaterial unterschiedliches Isoliermaterial aufweist;
Ausbilden eines zweiten Teils (94) der Öffnung in dem zweiten Teil der Isolierschicht, wobei sich der durchschnittliche Durchmesser des ersten Teils von dem durchschnittlichen Durchmesser des zweiten Teils unterscheidet; und
Aufwachsen, in jedem ersten und zweiten Teil der Öffnung, eines Halbleiterelements (20), das auf dem Träger aufliegt.

## Claims

1. An optoelectronic device (50; 60; 70; 75; 77; 90; 100; 110) comprising semiconductor elements (20; 76; 78), each semiconductor element resting on a support (16; 62) through an opening (54; 92, 94; 102, 104; 112) formed in a portion (52; 71; 96, 98; 106, 108) at least partially covering the support and at least a first part of which is insulating, **characterized in that** the height (H) of the opening is greater than or equal to 200 nm and smaller than or equal to 3,000 nm and **in that** the ratio of the height (H) to the smallest diameter of the opening (L; L₂; L₄; L₅) is greater than or equal to 1 and smaller than or equal to 10.

2. The optoelectronic device of claim 1, wherein the semiconductor elements (20; 76; 78) are nanowires, microwires, and/or nanometer- or micrometer-range pyramidal structures.

3. The optoelectronic device of claim 1 or 2, wherein the average diameter (L) of the opening (54) is constant all along the height of the portion (52; 71).

4. The optoelectronic device of claim 1 or 2, wherein the average diameter of the opening (112) decreases continuously form the top of the opening to the base of the opening.

5. The optoelectronic device of claim 1 or 2, wherein the opening successively comprises, from the base of the opening, a first part (92; 102) and a second part (94; 104), the average diameter of the first part being constant all along the height of the first part and the average diameter of the second part being constant all along the height of the second part and different from the average diameter on the first part.

6. The optoelectronic device of claim 5, wherein the average diameter (L₁) of the first part (92) is smaller than the average diameter (L₂) of the second part (94).

7. The optoelectronic device of claim 5, wherein the average diameter (L3) of the first part (102) is greater than the average diameter (L4) of the second part (104).

8. The optoelectronic device of any of claims 1 to 7, wherein the first part of the portion (96, 98; 106, 108) comprises at least one of the materials from among silicon oxides, silicon nitrides, and aluminum oxides.

9. The optoelectronic device of any of claims 1 to 8, wherein at least a second part of the portion (96, 98; 106, 108) comprises at least one material which is not electrically conductive.

10. The optoelectronic device of any of claims 1 to 7, wherein the second part of the portion (96, 98; 106, 108) comprises at least one of the materials selected from the group comprising AlN, Ti, TiN, Ta, TaN, Hf, HfN, W, WN, Mo.

11. The optoelectronic device of any of claims 1 to 10, wherein each semiconductor element (20; 76, 77) is mainly made of a III-V compound.

12. The optoelectronic device of claim 11, wherein each semiconductor element (20; 76, 78) mainly comprises gallium nitride.

13. A method of manufacturing an optoelectronic device comprising the steps of:
forming, on a support (16; 62), a portion (52; 71; 96, 98; 106, 108) at least partially covering the support and having at least one first insulating part;
forming an opening (54; 92, 94; 102, 104; 112) crossing the portion, the height (H) of the opening being greater than or equal to 200 nm and smaller than or equal to 3, 000 nm and the ratio of the height to the average diameter of the opening at the top of the portion being greater than or equal to 1 and smaller than or equal to 10; and
growing in each opening a semiconductor element (20; 76, 77) resting on the support.

14. The method of claim 13, wherein the height (H) of the portion (52; 71; 96, 98; 106, 108) is greater than or equal to 100 nm and smaller than or equal to 1,000 nm.

15. The method of claim 14, wherein the forming of the portion (52; 71; 96, 98; 106, 108) comprises the steps of:
depositing a first insulating layer (106) comprising a first insulating material;
depositing a second insulating layer (108) comprising a second insulating material different from the first insulating material;
forming a first part (104) of the opening in the first insulating layer;
forming a second part (102) of the opening in the second part of the insulating layer, the average diameter of the first part being different from the average diameter of the second part; and
growing in each first and second part of the opening a semiconductor element (20) resting on the support.

16. The method of claim 14, wherein the forming of the portion (52; 71; 96, 98; 106, 108) comprises the steps of:
depositing a first insulating layer (96) comprising a first insulating material;
forming a first part (92) of the opening in the first insulating layer;
depositing a second insulating layer (98) comprising a second insulating material different from the first insulating material;
forming a second part (94) of the opening in the second part of the insulating layer, the average diameter of the first part being different from the average diameter of the second part; and
growing in each first and second part of the opening a semiconductor element (20) resting on the support.
